Europäisches Patentamt

European Patent Office

Office européen des brevets

(11) Numéro de publication : **0 481 846 A1**

# (12) DEMANDE DE BREVET EUROPEEN

(21) Numéro de dépôt : **91402675.2**

(22) Date de dépôt : **08.10.91**

(51) Int. Cl.⁵ : **H01L 23/10**, H01L 21/50

(30) Priorité : **12.10.90 FR 9012607**

(43) Date de publication de la demande :
**22.04.92 Bulletin 92/17**

(84) Etats contractants désignés :
**DE GB IT SE**

(71) Demandeur : **THOMSON-CSF**
**51, Esplanade du Général de Gaulle**
**F-92800 Puteaux (FR)**

(72) Inventeur : **Reynal, Florence**
**THOMSON-CSF, SCPI, Cédex 67**
**F-92045 Paris la Défense (FR)**
Inventeur : **Goujard, Dominique**
**THOMSON-CSF, SCPI, Cédex 67**
**F-92045 Paris la Défense (FR)**

(74) Mandataire : **Benoit, Monique et al**
**THOMSON-CSF SCPI**
**F-92045 PARIS LA DEFENSE CEDEX 67 (FR)**

(54) **Procédé d'assemblage d'un capot métallique sur un substrat portant un circuit intégré.**

(57)   L'invention concerne un procédé d'assemblage de deux couches constituées de matériaux ayant des propriétés mécaniques différentes, et son application à l'encapsulation hermétique de circuits hybrides.

Le procédé selon l'invention pour assembler une couche (5) d'un matériau $M_1$ et une couche (3) d'un matériau $M_2$ est caractérisé en ce qu'il consiste à interposer, entre les deux couches, une couche intermédiaire (4) constituée par un mélange du matériau $M_1$ et du matériau $M_2$. De préférence ce mélange est constitué par 25 à 75 % en poids du matériau $M_1$ et 75 à 25 % en poids de matériau $M_2$.

Le procédé selon l'invention est particulièrement utile pour l'encapsulation de circuits intégrés et plus particulièrement de circuits hybrides, lors de l'assemblage du substrat (8) en céramique portant le circuit et du capot métallique (1).

FIG.1

La présente invention concerne l'encapsulation hermétique de circuits hybrides.

Le problème de la suppression ou, à défaut, de la limitation de l'humidité dans les boîtiers de composants électroniques est un problème aigu. Le contaminant ayant un rôle le plus important et le plus néfaste sur le plan de la fiabilité d'un composant discret ou d'un circuit intégré est l'eau de l'ambiance environnante. En effet, l'humidité est susceptible de corroder les plots de connexion du circuit ; elle permet également aux ions de se solubiliser, ce qui renforce la corrosion. Cet effet est très sensible sur les circuits intégrés, et l'est d'autant plus que l'échelle d'intégration est plus élevée, c'est à dire que les plots de connexion sont plus petits. Une solution à ce problème consiste à fermer les boîtiers sous atmosphère de gaz neutre, par exemple sous azote, qui doit rester dans les boîtiers.

Pour les applications à environnement sévère et hautes performances, telles que les applications militaires ou spatiales, il est connu d'utiliser des boîtiers de composants dont le fond est un matériau isolant et le capot en métal, le capot étant scellé hermétiquement sur le fond, un dégazage avant mise sous boîtier étant en outre généralement prévu. Le fond du boîtier constitue le substrat du circuit, par exemple d'un circuit hybride multicouche. Il peut être en céramique. Le capot métallique est constitué par un cadre surmonté par un couvercle. Le cadre peut être un cadre annulaire simple, ou bien un cadre comportant des alvéoles.

Les matériaux à assembler pour obtenir de tels boîtiers ont des caractéristiques différentes. D'une part, le substrat est en céramique et porte un circuit de type multi- couche sérigraphié. D'autre part, le cadre métallique a un coefficient de dilatation qui n'est pas parfaitement adapté à celui de la céramique. En outre, la liaison doit être assurée par une brasure dont le coefficient de dilatation est fortement supérieur à celui des matériaux à assembler. Pour réaliser cette brasure, un traitement spécifique par voie chimique ou électrolytique doit être réalisé sur le métal afin d'assurer une mouillabilité de la brasure. Du côté céramique, le multicouche comportant des pistes conductrices doit être isolé de la pièce métallique afin d'éviter les court-circuits. Il est donc nécessaire de réaliser un dépôt de pâte diélectrique par sérigraphie sous l'emplacement prévu pour le cadre métallique. La brasure n'accrochant pas sur le diélectrique, une encre de sérigraphie conductrice ( encre métallique ) doit être déposée sur ce diélectrique à l'emplacement du cadre métallique.

Sur ce petites dimensions, les contraintes mécaniques ne créent pas de fracture à l'interface de l'assemblage. L'étanchéité au niveau des différentes interfaces reste satisfaisante après de nombreux cycles thermiques. Toutefois, au - delà de quelques centimètres carrés, l'interface diélectrique/sérigraphie métallique est trop fragile.

Les études réalisées par la demanderesse ont permis de réduire de façon significative le problème de l'étanchéité de tels assemblages.

La présente invention a pour objet un procédé d'assemblage d'un capot métallique sur un substrat portant un circuit intégré selon lequel on applique successivement, par sérigraphie, sur une zone annulaire du substrat venant en regard du contour du capot, une couche de pâte diélectrique isolant, du capot métallique, des pistes conductrices portées par le substrat, puis une couche d'encre métallique servant d'accrochage à une couche de brasure permettant la fixation du capot métallique. Elle est remarquable en ce que le procédé consiste en outre à appliquer par sérigraphie entre la couche de pâte diélectrique et la couche d'encre métallique une couche intermédiaire constituée d'un mélange de la pâte diélectrique et de l'encre métallique

La création de la couche intermédiaire permet de réaliser un gradient de caractéristiques mécaniques, qui assure une meilleure cohésion de part et d'autre de ladite couche intermédiaire.

Le procédé de la présente invention est expliqué en détail par exemple ci-après, donné à titre illustratif.

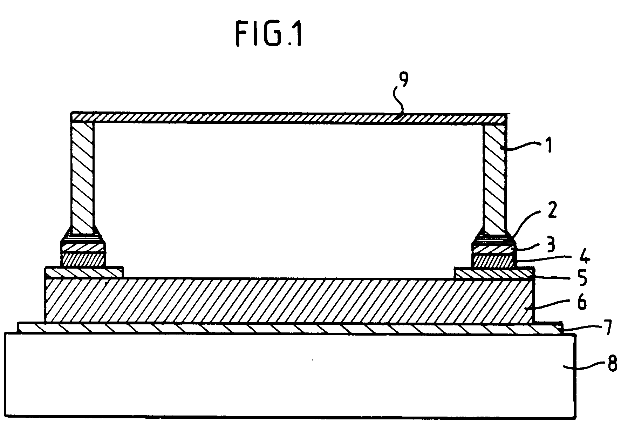

La figure 1 représente une vue en coupe d'un boîtier obtenu par le procédé de l'invention. Sur cette figure :

(1) représente un cadre métallique supportant un couvercle (9), l'ensemble formant le capot métallique ;

(2) représente une couche de brasure ;

(3) représente une couche métallique ;

(4) représente une couche intermédiaire ;

(5) représente une couche diélectrique ;

(6) représente un circuit multicouche ;

(7) représente les pistes conductrices entrées/sorties

(8) représente le substrat servant de fond de boîtier.

Le substrat (8) est constitué avantageusement par une céramique telle que l'alumine. Il porte un circuit du type multicouche sérigraphié (6) et des pistes entrées/sorties (7).

La zone annulaire multicouche (6) sur laquelle doit être fixé le cadre métallique (1) est revêtue par sérigraphie d'une couche de pâte de sérigraphie diélectrique (5). Le matériau diélectrique peut être en verre, par exemple un verre de silicoboroaluminate de baryum ou de plomb, et d'alumine.

La couche intermédiaire (4) est obtenue en déposant sur la couche annulaire diélectrique (5), par sérigraphie, un mélange en pâte crue constitué par la pâte de sérigraphie diélectrique telle qu'utilisée pour la couche (5) et par une encre , de sérigraphie métallique. La mélange ainsi déposé est séché et cuit selon les techniques classiques. La couche (4) a de préférence, une épaisseur de l'ordre de 20 μ.

De préférence, le mélange est constitué par 25 à 75 % de pâte de sérigraphie diélectrique et 75 à 25 % d'encre de sérigraphie métallique. Un mélange à environ 50/50 est tout particulièrement préféré.

Ensuite la couche métallique est formée par sérigraphie sur la zone annulaire précitée à partir d'une encre de sérigraphie métallique identique à celle utilisée pour la couche intermédiaire (4). Cette encre peut être une encre à l'or, une encre à l'or-platine ou encore une encre à l'argent-palladium.

Ensuite, ladite zone annulaire est revêtue d'une couche de brasure (2) et un cadre métallique annulaire (1) est fixé sur la zone revêtue de brasure par fusion de la brasure.

Pour terminer, un couvercle (9) est fixé de façon étanche sur le cadre (1), par exemple avec une fermeture par laser.

Un boîtier comportant un substrat ayant une superficie supérieure de dm$^2$ a ainsi été obtenu. Son étanchéité et sa tenue aux conditions d'environnement en température et en dépression selon les normes militaires ont été vérifiées.

Par ailleurs, des tests d'arrachement en traction et en cisaillement ont été effectuées d'une part sur un assemblage constitué par les couches 1 à 8 selon l'invention, et d'autre part sur un assemblage comportant les couches 1 à 3 et 5 à 8 selon l'art antérieur. Dans l'assemblage selon l'invention, la charge de rupture est de 92 kg/cm$^2$. Dans l'assemblage selon l'art antérieur, elle est de 55 kg/cm$^2$. En outre, la rupture se produit, non plus entre la couche diélectrique et la couche métallique, mais au niveau de la céramique. Il apparaît ainsi que selon le procédé selon l'invention permet de renforcer notablement l'assemblage entre deux couches de matériaux différents.

## Revendications

1. Procédé d'assemblage d'un capot métallique (1, 9) sur un substrat (8) portant un circuit intégré selon lequel on applique successivement, par sérigraphie, sur une zone annulaire du substrat (8) venant en regard du contour du capot (1, 9), une couche de pâte diélectrique (5) isolant du capot métallique (1, 9), des pistes conductrices (7) portées par le substrat (8), puis une couche d'encre métallique (3) servant d'accrochage à une couche de brasure (2) permettant la fixation du capot métallique (1, 9) caractérisé en ce qu'il consiste en outre à appliquer par sérigraphie entre la couche de pâte diélectrique (5) et la couche d'encre métallique (3) une couche intermédiaire (4) constituée d'un mélange de la pâte diélectrique et de l'encre métallique.

2. Procédé selon la revendication 1, caractérisé en ce que le mélange utilisé pour la couche intermédiaire (4) est constitué de 25 à 75 % en poids de la dite pâte diélectrique et de 75 à 25 % en poids de la dite encre métallique.

3. Procédé selon la revendication 1, caractérisé en ce que le mélange utilisé pour la couche intermédiaire (4) est constitué par environ 50 % en poids de la dite pâte diélectrique et environ 50 % en poids de la dite encre métallique.

4. Procédé selon la revendication 1, caractérisé en ce que la dite pâte diélectrique est un verre constitué d'alumine et de silicoboroaluminate de baryum ou de plomb.

5. Procédé selon la revendication 1, caractérisé en ce que la dite encre métallique est constituée d'un métal ou alliage choisi parmi l'or, l'or-platine ou l'argent-palladium.

# FIG.1

Office européen
des brevets

**RAPPORT DE RECHERCHE EUROPEENNE**

Numero de la demande

EP    91 40 2675

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | GB-A-1 468 973 (UNITED KINGDOM ATOMIC ENERGY AUTHORITY) <br> * le document en entier * | 1,4,5 | H01L23/10 <br> H01L21/50 |
| A | | 2,3 | |
| X | GB-A-1 431 919 (UNITED KINGDOM ATOMIC ENERGY AUTHORITY) <br> * le document en entier * | 1,4,5 | |
| A | --- | 2,3 | |
| A | PATENT ABSTRACTS OF JAPAN <br> vol. 12, no. 111 (E-598)8 Avril 1988 <br> & JP-A-62 241 356 ( HITACHI LTD ) 22 Octobre 1987 <br> * abrégé * | 1 | |
| A | PATENT ABSTRACTS OF JAPAN <br> vol. 11, no. 23 (E-473)22 Janvier 1987 <br> & JP-A-61 193 473 ( FUJITSU LTD ) 27 Août 1986 <br> * abrégé * | 1 | |
| A | PATENT ABSTRACTS OF JAPAN <br> vol. 9, no. 263 (E-351)19 Octobre 1985 <br> & JP-A-60 110 156 ( HITACHI SEISAKUSHO K.K. ) 15 Juin 1985 <br> * abrégé * | 1 | **DOMAINES TECHNIQUES RECHERCHES (Int. Cl.5 )** <br><br> H01L |
| A | US-A-4 704 626 (OLIN CORP.) <br> * colonne 8, ligne 56 - colonne 9, ligne 30; figure 3 * | 1 | |
| A | EP-A-0 178 481 (OLIN CORP.) <br> * le document en entier * | 1 | |

Le présent rapport a été établi pour toutes les revendications

| Lieu de la recherche | Date d'achèvement de la recherche | Examinateur |
|---|---|---|
| LA HAYE | 11 FEVRIER 1992 | ZEISLER P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
&............................................................
& : membre de la même famille, document correspondant

EPO FORM 1503 03.82 (P0402)